# EUROPÄISCHE PATENTSCHRIFT

(11) **EP 2 655 688 B1**
(45) Veröffentlichungstag und Bekanntmachung des Hinweises auf die Patenterteilung: **17.02.2021**
(21) Anmeldenummer: 11804666.3
(22) Anmeldetag: 16.12.2011
(51) Int. Cl.: F24C 15/16, C23C 16/02, C23C 16/40, F24C 15/00

(54) **VERFAHREN ZUM HERSTELLEN EINES PYROLYSETAUGLICHEN BAUTEILS EINES GARGERÄTS**
METHOD FOR PRODUCING A PYROLYSIS COMPATIBLE COMPONENT FOR A COOKING APPLIANCE
PROCÉDÉ DE FABRICATION D'UN ÉLÉMENT APTE À LA PYROLYSE D'UN APPAREIL DE CUISSON

(30) Priorität: 22.12.2010 DE 102010063887
(43) Veröffentlichungstag der Anmeldung: 30.10.2013
(73) Patentinhaber: BSH Hausgeräte GmbH, 81739 München (DE)
(72) Erfinder: HERBOLSHEIMER, Jochen, 83308 Trostberg (DE); JÖRDENS, Frank, 83278 Traunstein (DE); SALOMON, Jürgen, 83308 Trostberg (DE); SCHALLER, Philipp, 83301 Traunreut (DE); SCHMIDMAYER, Gerhard, 83093 Bad Endorf (DE)
(86) Internationale Anmeldenummer: PCT/EP2011/073115
(87) Internationale Veröffentlichungsnummer: WO 2012/084733

(56) Entgegenhaltungen:
- EP-A1- 1 580 299
- EP-A2- 1 388 593
- EP-A2- 1 388 594
- DE-A1-102008 059 909

## Beschreibung

Die Erfindung betrifft ein Verfahren zum Herstellen eines pyrolysetauglichen Bauteils eines Gargeräts, wobei das Gargerät zur Durchführung eines Pyrolysebetriebs ausgebildet ist. Bei dem Verfahren wird ein Grundelement des Bauteils bereitgestellt und beschichtet.

Aus der EP 1 580 299 A1 ist ein Verfahren bekannt, mittels welchem die Beschichtung durch ein PECVD-Verfahren auf ein metallisches Bauteil erfolgen kann. Die Bauteile können vielerlei Komponenten aus der Haushaltsgerätetechnik sein.

Bei Gargeräten, wie einem Backofen, ist es bekannt, dass in dem Garraum Traggestelle zur Aufnahme von Gargutträgern, wie beispielsweise eine Grillpfanne, ein Backblech oder einen Grillrost, vorgesehen sind. Darüber hinaus können auch Auszugsvorrichtungen, wie beispielsweise Teleskopauszüge, vorgesehen sein, auf denen derartige Gargutträger positioniert werden können. Bei Backöfen, die einen Pyrolysebetrieb ermöglichen, treten in diesem Pyrolysebetrieb sehr hohe Temperaturen auf, die auf die Bauteile im Garraum einwirken. Herkömmliche Bauteile, die während des Pyrolysebetriebs im Garraum belassen werden können, sind mit Emaille beschichtet. Diese sind jedoch sehr aufwändig herstellbar und dadurch auch teuer. Darüber hinaus verlieren sie mit der Dauer den typischen Edelstahleindruck. Darüber hinaus sind emaillierte Bauteile schlagempfindlich, so dass es zu Abplatzern von der Emaillebeschichtung kommen kann.

Es ist Aufgabe der vorliegenden Erfindung, ein Verfahren zum Herstellen eines pyrolysetauglichen Bauteils eines Gargeräts zu schaffen, bei dem im Hinblick auf die Einwirkung in einem Pyrolysebetrieb eine größere Verschleißarmut gegeben ist.

Diese Aufgabe wird durch ein Verfahren, welches die Merkmale nach Anspruch 1 aufweist, gelöst.

Bei einem erfindungsgemäßen Verfahren zum Herstellen eines pyrolysetauglichen Bauteils eines Gargeräts, welches zur Durchführung eines Pyrolysebetriebs ausgebildet ist, wird ein Grundelement des Bauteils bereitgestellt und beschichtet. Auf dem Grundteil wird eine Siliziumdioxidschicht durch eine PECVD (plasma-enhanced chemical vapor deposition)-Abscheidung erzeugt. Durch eine derartige spezifische Aufbringungsart einer derartig spezifischen Materialschicht wird erreicht, dass die Pyrolysetauglichkeit des Bauteils deutlich verbessert ist. Die Robustheit und die Verschleißarmut derartiger Bauteile gegenüber den Einwirkungen bei einer Pyrolyse kann wesentlich erhöht werden. Insbesondere kann durch eine derartige Ausgestaltung erreicht werden, dass die bei herkömmlichen Bauteilen auftretende Verfleckung beziehungsweise die Anlauffarben bei der Pyrolyse verhindert werden können. Der metallische Charakter des Bauteils bleibt darüber hinaus erhalten.

Insbesondere ist es ermöglicht, dass ein derartiges pyrolysetaugliches Bauteil emaillefrei beschichtet wird und somit das Auftreten von Abplatzern verhindert werden kann.

Es ist vorgesehen, dass die Siliziumdioxidschicht durch eine Hochrate-PECVD-Abscheidung erzeugt wird, bei welcher diese Schicht mit einer Geschwindigkeit von größer 0,5 µm/min, insbesondere etwa 1 µm/min, erzeugt wird, Eine derartige Vorgehensweise ist besonders vorteilhaft, da die Siliziumdioxidschicht besonders fest und stabil aufgebracht werden kann.

Im Vergleich zur Emaillierung ist dies ein besonders ressourcenschonendes Beschichtungsverfahren, da keine hohen Einbrenntemperaturen erforderlich sind.

Vorzugsweise wird vorgesehen, dass die Siliziumdioxidschicht mit einer Dicke kleiner oder gleich 10 µm, insbesondere zwischen 50 nm und 2000 nm, erzeugt wird. Bereits eine derartige dünne Siliziumdioxidschicht auf dem insbesondere metallischen Grundteil reicht aus, um die oben genannten Vorteile und Verbesserungen einwandfrei erzielen zu können. Dadurch kann auch ein sehr materialsparendes Beschichtungsverfahren ermöglicht werden.

Vorzugsweise wird vorgesehen, dass bei der PECVD-Abscheidung ein mikrowelleninduziertes Plasma bei 2,45 GHz erzeugt wird. Der Schutz gegen thermische Anlauffarben und chemischen Angriff durch Lebensmittelreste auf das Bauteil kann dadurch besonders vorteilhaft erzielt werden.

Vorzugsweise wird die Siliziumdioxidbeschichtung im Vakuum unter Verwendung des oben genannten mikrowelleninduzierten Plasmas erzeugt. Das so erzeugte Plasma regt den so genannten Precursor (beispielsweise Hexamethyldisiloxan) so an, dass eine im Vergleich zu den üblichen Plasmaverfahren sehr dichte, gut haftende porenfreie Schicht auf dem Bauteil erzeugt wird.

Vorzugsweise ist vorgesehen, dass in einen die Siliziumdioxidschicht umfassenden Schichtenaufbau Fremdatome eingebracht werden. Durch Variation der Prozessparameter bei der Abscheidung ist es möglich, diese Fremdatome so in den Schichtenverbund einzubauen, dass Gradientenschichten erzeugt werden. Dadurch können zum Beispiel unterschiedliche thermische Ausdehnungskoeffizienten zwischen dem Grundteil und der Beschichtung kompensiert oder die Oberflächenenergie der Beschichtung variiert werden.

Vorzugsweise ist vorgesehen, dass als Fremdatome Kohlenstoff und/oder Wasserstoff eingebracht werden. Die oben genannten Eigenschaften können dadurch besonders präzise und dauerhaft erzielt werden.

Vorzugsweise ist vorgesehen, dass der Schichtenaufbau mit einer ersten Schicht ausgebildet wird, die Silizium, Sauerstoff, Kohlenstoff und Wasserstoff aufweist, und als dem Grundteil nächstgelegene Schicht ausgebildet wird. Vorzugsweise ist diese erste Schicht eine SiOₓC_{y}H_{z}-Schicht (mit 0≤x,y,z≤2).

Vorzugsweise wird vorgesehen, dass der Schichtenaufbau mit einer zweiten Schicht ausgebildet wird, die Silizium und Kohlenstoff aufweist, und auf der ersten Schicht ausgebildet wird, wobei die Konzentration von Kohlenstoff in der zweiten Schicht kleiner als in der ersten Schicht ausgebildet wird. In Bezug auf die zwei Schichten wird somit ein Gradient in der Konzentration eingestellt, wobei dies insbesondere die Kohlenstoffatome und Sauerstoffatome betrifft. Die oben genannten Vorteile im Hinblick auf die Angleichung der thermischen Ausdehnungskoeffizienten oder die Variation der Oberflächenenergie kann dadurch verbessert werden.

Es ist auch möglich, dass der Schichtenaufbau mit einer zweiten Schicht ausgebildet wird, die Silizium , Sauerstoff, Kohlenstoff und Wasserstoff aufweist, und auf der ersten Schicht ausgebildet wird, wobei die Konzentration von Sauerstoff, Kohlenstoff und Wasserstoff in der zweiten Schicht eine andere ist als in der ersten Schicht. In Bezug auf die zwei Schichten wird somit ein Gradient in der Konzentration eingestellt, wobei dies insbesondere die Wasserstoffatome, Kohlenstoffatome und Sauerstoffatome betrifft. Die oben genannten Vorteile im Hinblick auf die Angleichung der thermischen Ausdehnungskoeffizienten oder die Variation der Oberflächenenergie kann dadurch verbessert werden.

Vorzugsweise wird vorgesehen, dass die Siliziumdioxidschicht quasi als dritte Schicht auf der zweiten Schicht ausgebildet wird.

Ein derartiger Schichtenaufbau ist im Hinblick auf die oben genannten Vorteile und Verbesserungen besonders hervorzuheben.

Es kann vorgesehen sein, dass die drei Schichten des Schichtenaufbaus mit jeweils gleicher Schichtdicke ausgebildet werden. Es kann jedoch auch vorgesehen sein, dass die drei Schichten mit unterschiedlichen Schichtdicken erzeugt werden.

Vorzugsweise ist das Grundteil aus Metall ausgebildet.

Vorzugsweise ist das Bauteil ein Gitterrost oder ein Gargutträger oder eine Teleskopauszugsvorrichtung zur Aufnahme eines Gargutträgers. Als Gargutträger kann beispielsweise ein Gitterrost, ein Backblech oder eine Grillpfanne vorgesehen sein. Das Traggestell zur Aufnahme eines Gargutträgers kann beispielsweise aus Stäben als Gittergestell ausgebildet sein und in den Garraum zerstörungsfrei reversibel anbringbar und wieder entnehmbar sein.

Ausführungsbeispiele der Erfindung werden nachfolgend anhand schematischer Zeichnungen näher erläutert. Es zeigen:
- Fig. 1: eine vereinfachte Darstellung eines Traggestells zur Aufnahme eines Gargutträgers;
- Fig. 2: eine Teleskopauszugsvorrichtung zur Aufnahme eines Gargutträgers; und
- Fig. 3: eine Schnittdarstellung durch einen Stab des Traggestells gemäß Fig. 1.

In den Figuren werden gleiche oder funktionsgleiche Elemente mit den gleichen Bezugszeichen versehen.

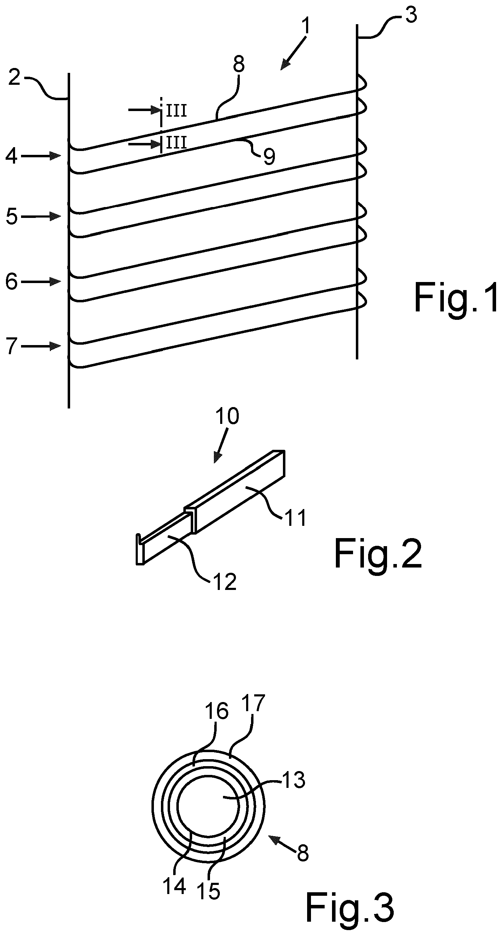

In Fig. 1 ist ein Traggestell 1 gezeigt, welches aus Stäben aufgebaut ist. Das Traggestell 1 kann in den Garraum eingebracht werden und beispielsweise an einer vertikalen Seitenwand einer Muffel angeordnet werden. Das Traggestell 1 umfasst zwei vertikale Haltestäbe 2 und 3, an denen eine Vielzahl von Führungsstäben angeordnet ist. Diese sind jeweils paarweise einander zugeordnet und bilden jeweils eine Einschubführung. Im Ausführungsbeispiel ist vorgesehen, dass vier Einschubführungen 4, 5, 6 und 7 vorgegeben sind, die in vertikaler Richtung betrachtet auf unterschiedlichen Höhenniveaus liegen. Dadurch werden auch Einschubebenen für einen Gargutträger in der Muffel vorgegeben. Beispielsweise umfasst die Einschubführung 4 zwei parallel zueinander orientierte Führungsstäbe 8 und 9, zwischen denen dann der Gargutträger mit einem Teilbereich eingeschoben und gehalten werden kann. Das Traggestell 1 ist als pyrolysetaugliches Bauteil hergestellt, welches ein Grundteil aus Metall aufweist, an dessen Außenseite ein Schichtenverbund aufgebracht ist. Dieser ist durch ein Hochrate-PECVD-Abscheiden erzeugt.

In Fig. 2 ist in einer vereinfachten perspektivischen Darstellung eine Teleskopauszugsvorrichtung 10 gezeigt, welcher ebenfalls zur Aufnahme eines Gargutträgers ausgebildet ist und in einem Garraum an einer vertikalen Seitenwand einer Muffel befestigbar ist. Die Teleskopauszugsvorrichtung 10 umfasst im Ausführungsbeispiel zwei Schienen 11 und 12, wobei die Schiene 11 die ortsfest angebrachte Schiene ist und die Schiene 12 die dazu relativ bewegbare Auszugsschiene ist. Auch diese Teleskopauszugsvorrichtung 10 ist ein pyrolysetaugliches Bauteil, welches jeweils aus einem Grundteil ausgebildet ist, das außenseitig mit einem Schichtenverbund beschichtet ist, wobei dies durch ein Hochrate-PECVD-Abscheiden erzeugt wurde. Der Schichtenverbund kann bei beiden Bauteilen bis zu drei Schichten aufweisen, wobei zunächst auf dem Grundteil eine SiOₓC_{y}H_{z} -Schicht als erste Schicht ausgebildet ist und darauf als zweite Schicht dann eine SiOₖCₗHₘ -Schicht ausgebildet ist (mit 0≤x,y,z,k,l,m≤2 und x≠k; y≠l, z≠m). Auf dieser zweiten Schicht nach außen hin anschließend ist dann eine Siliziumdioxidschicht ausgebildet.

Dazu ist in Fig. 3 eine Schnittdarstellung durch den Stab 8 gezeigt. Es ist dabei das Grundteil 13 zu erkennen. Auf dessen Außenseite 14 ist die erste Schicht 15 ausgebildet, die, wie bereits oben erwähnt, die SiOₓC_{y}H_{z}-Schicht ist. Auf diese ist dann die zweite Schicht 16 aufgebracht, welche eine SiOₖCₗHₘ -Schicht ist. Außen liegend ist dann die Siliziumdioxidschicht 17 ausgebildet. Die drei Schichten 15 bis 17 weisen im Hinblick auf die Fremdatome Kohlenstoff und Wasserstoff einen Konzentrationsgradienten auf, der von innen nach außen abnimmt.

Darüber hinaus sind die Schichten 15 bis 17 mit einem Hochrate-PECVD-Abscheideverfahren aufgebracht, wobei die Schichten mit einer Geschwindigkeit von bis etwa 6 µm/min erzeugt werden (vorzugsweise 0,5 - 1 µm/min). Es wird dabei ein mikrowelleninduziertes Plasma bei 2,45 GHz erzeugt. Die Erzeugung der Siliziumdioxidschicht 17 erfolgt im Vakuum unter Verwendung dieses mikrowelleninduzierten Plasmas.

### Bezugszeichenliste

- 1: Traggestell
- 2,3: Haltestäbe
- 4, 5, 6, 7: Einschubführungen
- 8, 9: Führungsstäbe
- 10: Teleskopauszugsvorrichtung
- 11, 12: Schienen
- 13: Grundteil
- 14: Außenseite
- 15, 16, 17: Schichten

## Patentansprüche

1. Verfahren zum Herstellen eines pyrolysetauglichen Bauteils (1, 10) eines Gargeräts, welches zur Durchführung eines Pyrolysebetriebs ausgebildet ist, bei welchem ein Grundteil (13) des Bauteils (1, 10) bereitgestellt und beschichtet wird, wobei auf dem Grundteil (13) eine Siliziumdioxidschicht (17) erzeugt wird, **dadurch gekennzeichnet, dass** die Siliziumdioxidschicht (17) durch eine Hochrate-PECVD-Abscheidung erzeugt wird, bei welcher die Schicht (17) mit einer Geschwindigkeit von größer 0,5 µm/min, insbesondere etwa 1 µm/min, erzeugt wird.

2. Verfahren nach Anspruch 1, **dadurch gekennzeichnet, dass** die Siliziumdioxidschicht (17) mit einer Dicke kleiner oder gleich 10 µm, insbesondere zwischen 50 nm und 2000 nm, erzeugt wird.

3. Verfahren nach einem der vorhergehenden Ansprüche, **dadurch gekennzeichnet, dass** bei der PECVD-Abscheidung ein mikrowelleninduziertes Plasma bei 2,45 GHz erzeugt wird.

4. Verfahren nach einem der vorhergehenden Ansprüche, **dadurch gekennzeichnet, dass** in einen die Siliziumdioxidschicht (17) umfassenden Schichtenaufbau auf dem Grundteil (13) Fremdatome eingebracht werden.

5. Verfahren nach Anspruch 4, **dadurch gekennzeichnet, dass** als Fremdatome Kohlenstoff und/oder Wasserstoff eingebracht wird.

6. Verfahren nach Anspruch 4 oder 5, **dadurch gekennzeichnet, dass** die Fremdatome mit einem definierten Konzentrationsgradienten in Richtung der Schichtdicke der Siliziumdioxidschicht (17) eingebracht werden.

7. Verfahren nach Anspruch 6, **dadurch gekennzeichnet, dass** der Schichtenaufbau mit einer ersten Schicht (15) ausgebildet wird, die Silizium, Sauerstoff, Kohlenstoff und Wasserstoff aufweist, und als dem Grundteil (13) nächstgelegene Schicht (15) ausgebildet wird.

8. Verfahren nach Anspruch 7, **dadurch gekennzeichnet, dass** der Schichtenaufbau mit einer zweiten Schicht (16) ausgebildet wird, die Silizium und Kohlenstoff aufweist, und auf der ersten Schicht (15) ausgebildet wird, wobei die Konzentration von Sauerstoff, Kohlenstoff und Wasserstoff in der zweiten Schicht (16) eine andere ist als in der ersten Schicht (15).

9. Verfahren nach Anspruch 8, **dadurch gekennzeichnet, dass** die Siliziumdioxidschicht (17) auf der ersten oder zweiten Schicht (16) ausgebildet wird.

10. Verfahren nach einem der vorhergehenden Ansprüche, **dadurch gekennzeichnet, dass** das Grundteil (13) aus Metall ausgebildet wird.

## Claims

1. Method for producing a pyrolysis compatible component (1, 10) for a cooking appliance, the cooking appliance being configured to carry out a pyrolysis operation, in which method a base part (13) of the component (1, 10) is provided and coated,
wherein a silicon dioxide coating (17) is generated on the base part (13), **characterised in that** the silicon dioxide coating (17) is generated by a high-rate PECVD deposition, with which the layer (17) is generated at a speed faster than 0.5 µm/min, in particular around 1 µm/min.

2. Method according to claim 1, **characterised in that** the silicon dioxide coating (17) is generated with a thickness smaller than or equal to 10 µm, in particular between 50 nm and 2000 nm.

3. Method according to one of the preceding claims, **characterised in that** a microwave-induced plasma is generated at 2.45 GHz during PECVD deposition.

4. Method according to one of the preceding claims, **characterised in that** impurity atoms are introduced into a coating structure encompassing the silicon dioxide coating (17) on the base part (13).

5. Method according to claim 4, **characterised in that** carbon and/or hydrogen is/are introduced as the impurity atoms.

6. Method according to claim 4 or 5, **characterised in that** the impurity atoms are introduced with a defined concentration gradient in the direction of the coating thickness of the silicon dioxide coating (17).

7. Method according to claim 6, **characterised in that** the coating structure is configured with a first coating (15), which has silicon, oxygen, carbon and hydrogen and is configured as the coating (15) next to the base part (13).

8. Method according to claim 7, **characterised in that** the coating structure is configured with a second coating (16), which has silicon and carbon and is configured on the first coating (15), the concentration of oxygen, carbon and hydrogen in the second coating (16) being different from in the first coating (15).

9. Method according to claim 8, **characterised in that** the silicon dioxide coating (17) is configured on the first or second coating (16).

10. Method according to one of the preceding claims, **characterised in that** the base part (13) is configured from metal.

## Revendications

1. Procédé de fabrication d'un composant apte à la pyrolyse (1, 10) d'un appareil de cuisson conçu pour exécuter une opération de pyrolyse, dans lequel une pièce de base (13) du composant (1, 10) est fournie et revêtue, et
dans lequel une couche de dioxyde de silicium (17) est produite sur la pièce de base (13),
**caractérisé en ce que** la couche de dioxyde de silicium (17) est produite par un dépôt PECVD à haute vitesse, dans lequel la couche (17) est produite à une vitesse supérieure à 0,5 µm/min, en particulier d'environ 1 µm/min.

2. Procédé selon la revendication 1, **caractérisé en ce que** la couche de dioxyde de silicium (17) est produite avec une épaisseur inférieure ou égale à 10 µm, en particulier entre 50 nm et 2000 nm.

3. Procédé selon l'une des revendications précédentes, **caractérisé en ce qu'**un plasma induit par micro-ondes à 2,45 GHz est produit lors du dépôt PECVD.

4. Procédé selon l'une des revendications précédentes, **caractérisé en ce que** des atomes étrangers sont introduits dans une structure de couches comprenant la couche de dioxyde de silicium (17) sur la pièce de base (13).

5. Procédé selon la revendication 4, **caractérisé en ce qu'**en tant qu'atomes étrangers, du carbone et/ou de l'hydrogène sont introduits.

6. Procédé selon la revendication 4 ou 5, **caractérisé en ce que** les atomes étrangers sont introduits avec un gradient de concentration défini en direction de l'épaisseur de la couche de dioxyde de silicium (17).

7. Procédé selon la revendication 6, **caractérisé en ce que** la structure de couches est formée avec une première couche (15) qui comprend du silicium, de l'oxygène, du carbone et de l'hydrogène, et qui est formée en tant que couche (15) la plus proche de la pièce de base (13).

8. Procédé selon la revendication 7, **caractérisé en ce que** la structure de couches est formée avec une deuxième couche (16), qui comprend du silicium et du carbone, et est formée sur la première couche (15), dans lequel la concentration d'oxygène, de carbone et d'hydrogène dans la deuxième couche (16) est différente de celle dans la première couche (15).

9. Procédé selon la revendication 8, **caractérisé en ce que** la couche de dioxyde de silicium (17) est formée sur la première ou la seconde couche (16).

10. Procédé selon l'une des revendications précédentes, **caractérisé en ce que** la pièce de base (13) est constituée de métal.
